# FASCICULE DE BREVET EUROPEEN

(11) **EP 3 147 223 B1**
(45) Date de publication et mention de la délivrance du brevet: **21.10.2020**
(21) Numéro de dépôt: 16188438.2
(22) Date de dépôt: 13.09.2016
(51) Int. Cl.: B64G 1/22, B64G 1/44

(54) **ENSEMBLE DEPLOYABLE**
AUSKLAPPBARE EINHEIT
DEPLOYABLE ASSEMBLY

(30) Priorité: 25.09.2015 FR 1501981
(43) Date de publication de la demande: 29.03.2017
(73) Titulaire: Thales, 92400 Courbevoie (FR)
(72) Inventeur: Ducarne, Julien, 06156 Cannes (FR); Grave, Julien, 06156 Cannes (FR); Reutenauer, Xavier, 06156 Cannes (FR)
(74) Mandataire: Marks & Clerk France

(56) Documents cités:
- EP-A2- 0 716 365
- EP-A2- 2 468 630
- JP-A- 2008 221 876
- US-A- 5 520 747
- US-A- 5 697 582
- US-A- 6 038 736

## Description

La présente invention concerne un ensemble déployable comprenant une structure porteuse et un ensemble de panneaux, par exemple un satellite et un générateur solaire composé de plusieurs panneaux solaires. Elle s'applique notamment au domaine des équipements spatiaux qui doivent être déployés en orbite et plus particulièrement aux équipements spatiaux pour satellites, tels que des générateurs solaires. Néanmoins, l'ensemble déployable selon l'invention peut être appliqué à tout autre domaine où il est nécessaire d'articuler un ou plusieurs panneaux par rapport à un objet. Le panneau peut être rigide ou flexible.

Un générateur solaire est constitué de panneaux solaires déployables et orientables. Un panneau solaire est un dispositif technologique énergétique constitué de capteurs solaires photovoltaïques destiné à convertir le rayonnement solaire en énergie électrique. Sur un satellite, le générateur solaire permet d'assurer l'apport d'énergie électrique et de faire fonctionner le matériel à son bord. Un générateur solaire peut être monté sur un satellite nécessitant un pointage précis, comme c'est le cas pour un satellite d'observation haute résolution. Les panneaux solaires peuvent présenter des modes de vibration basse fréquence non souhaités car perturbant le contrôle de la ligne de visée. Un satellite d'observation pointe souvent vers la Terre. Par contre, les panneaux solaires ne voient pas toujours le soleil, ce qui pose un problème d'apport d'énergie. Pour contrer ce problème, il est possible de monter davantage de panneaux solaires sur le satellite, mais cette solution présente l'inconvénient d'un surplus de masse et d'encombrement, surtout lors du lancement du satellite qui est contenu sous la coiffe de la fusée.

Il existe des satellites pouvant s'orienter selon leur phase d'activité. En phase d'observation, le satellite est complètement orienté vers le sol terrestre, un flux solaire réduit parvient sur le générateur solaire. En phase de stockage d'énergie, le satellite s'oriente de façon à ce que ses panneaux solaires soient orientés de manière optimale vers le soleil, c'est-à-dire avec la surface normale aux rayons. Néanmoins, lorsque le satellite passe au-dessus de sa station au sol, il se réoriente vers celle-ci afin de lui transférer les informations de sa mission. Il est donc difficile de concilier la mission d'observation avec la recharge énergétique.

De plus, le satellite tourne le dos au soleil et le télescope regarde l'espace froid à une température d'environ 3 Kelvin, au lieu de regarder vers la Terre en étant dans un environnement à une température d'environ 10 à 30 °C. Ces situations compliquent la régulation et le design thermique du télescope.

Par ailleurs, lorsque le satellite est dos au soleil, la cavité du télescope est parfois face au 'vent relatif' lié à la vitesse orbitale. Des particules de cet environnement peuvent éroder ou déformer les composants internes de la cavité. Sur la durée de vie requise du télescope, il est possible de rendre le télescope robuste face à de telles contraintes environnementales, mais cela signifie une plus haute exigence de la qualité du télescope, impliquant par là-même des coûts supplémentaires.

Certains satellites disposent de deux bras d'articulation. L'un des bras se situe dans le plan des panneaux solaires et permet le déploiement des panneaux solaires de la configuration stockée sur le satellite à la configuration déployée. Le deuxième bras est motorisé et permet d'orienter le générateur vers le soleil, le deuxième bras se terminant par exemple par deux branches, le bras est relié au satellite, les deux branches sont reliées au générateur solaire. Le bras permet une rotation de 360° du générateur solaire. Une telle configuration est décrite par exemple dans les documents JP2008/221876, US 5697582 et EP 0716365. Ainsi, il est possible pour le satellite de s'orienter de manière à pointer complètement vers le sol et d'orienter son générateur solaire vers le soleil pour assurer l'apport d'énergie. Mais cette solution impose la présence de deux articulations entre le satellite et le générateur solaire : l'articulation dédiée au déploiement des panneaux solaires et l'articulation dédiée à l'orientation du générateur solaire. Cette configuration n'est pas optimale pour la raideur du générateur solaire. La prise d'images doit être effectuée de manière très précise. Le satellite doit pouvoir changer d'attitude, parfois rapidement, avec une bonne stabilité et avoir une haute précision de pointage. La présence de deux articulations entre le satellite et le générateur solaire génère un problème d'amortissement. En effet, pendant le changement d'attitude du satellite, le générateur solaire peut alors être soumis à un premier mode de flexion excité par la manœuvre du satellite mais non contrôlé par le bras motorisé assurant l'orientation du générateur solaire. Les vibrations rendent alors la stabilisation du pointage difficile.

Le document EP 2468630 divulgue une structure déployable, constituée de panneaux formant une antenne équipée d'un générateur solaire, correspondant au préambule de la revendication 1.

L'invention vise à pallier tout ou partie des problèmes cités plus haut en proposant un ensemble déployable avec une seule articulation, c'est-à-dire sans un deuxième bras d'orientation, permettant de gagner en rigidité et de contrôler au mieux les vibrations.

A cet effet, l'invention a pour objet un ensemble déployable selon la revendication 1.

Selon un mode de réalisation, chacun des panneaux ayant des arêtes, l'axe principal de rotation est sur une première arête d'un premier des panneaux et les axes de rotation intermédiaires sont sur des arêtes non adjacentes.

Selon un autre mode de réalisation, l'axe principal de rotation et les axes de rotation intermédiaires sont des axes parallèles.

Selon un autre mode de réalisation, l'ensemble déployable comprend un capteur apte à déterminer la position de l'ensemble de panneaux, et il comprend un asservissement du motoréducteur en fonction de la position de l'ensemble de panneaux autour de l'axe principal de rotation.

Selon un autre mode de réalisation, le dispositif d'articulation comprend un moyen de précontrainte associé au second palier permettant d'éviter tout jeu dans le premier et le second palier.

Selon un mode particulier de réalisation, les panneaux de l'ensemble déployable sont des panneaux solaires et la structure porteuse est un satellite.

L'invention sera mieux comprise et d'autres avantages apparaîtront à la lecture de la description détaillée d'un mode de réalisation donné à titre d'exemple, description illustrée par le dessin joint dans lequel :
- la figure 1 représente schématiquement un ensemble de panneaux déployable et orientable selon l'art antérieur,
- la figure 2 représente schématiquement un ensemble de panneaux déployable et orientable selon l'invention,
- la figure 3 représente un dispositif d'articulation d'un ensemble de panneaux par rapport à une structure porteuse,
- la figure 4 représente schématiquement une boucle d'asservissement d'un motoréducteur en fonction de la position de l'ensemble de panneaux, selon l'invention,
- la figure 5 représente différentes positions successives autour de la Terre d'un satellite d'observation selon l'invention.

Par souci de clarté, les mêmes éléments porteront les mêmes repères dans les différentes figures.

L'invention est décrite dans le domaine des équipements spatiaux, dans le cas où les panneaux sont des panneaux solaires formant un générateur solaire et la structure porteuse est un satellite. Il est bien évident que l'invention peut s'appliquer à tout autre domaine dans lequel un ensemble de panneaux est relié à une structure porteuse pour former un ensemble déployable, par exemple un ensemble de panneaux d'antenne de télécommunication.

Dans cette demande, il est question d'un ensemble de panneaux, chacun des panneaux étant relié au panneau adjacent par une charnière définissant un axe de rotation intermédiaire, apte à passer d'une configuration stockée dans laquelle les panneaux sont repliés les uns sur les autres à une configuration déployée, par rotation des panneaux autour des axes de rotation intermédiaires respectifs, dans laquelle les panneaux sont disposés sensiblement dans un même plan. L'ensemble de panneaux est relié à une structure porteuse le long d'une arête d'un des panneaux, appelé premier panneau, par une liaison principale définissant un axe de rotation principal. Et chaque panneau est relié le long d'une de ses arêtes à son panneau voisin par une liaison intermédiaire définissant un axe de rotation intermédiaire. Chaque panneau est donc mobile en rotation autour de sa liaison intermédiaire et l'ensemble de panneaux est mobile en rotation autour de sa liaison principale. En configuration stockée, les panneaux sont repliés les uns sur les autres et sont empilés au niveau d'une face de la structure porteuse. La configuration stockée permet le stockage de l'ensemble des panneaux, notamment pendant la mise en orbite du satellite lorsque celui-ci est stocké sous la coiffe de la fusée, dans un espace restreint. En configuration déployée, les panneaux sont disposés sensiblement dans un même plan. Pour passer de la configuration stockée à la configuration déployée, le premier panneau a effectué un mouvement de rotation autour de la liaison principale et chacun des panneaux a effectué un mouvement de rotation autour de sa liaison intermédiaire. La configuration déployée correspond à la configuration opérationnelle de l'ensemble de panneaux. Autrement dit, c'est en configuration déployée que l'ensemble de panneaux est orienté en fonction des besoins du satellite. L'ensemble de panneaux en configuration déployée est orienté vers le soleil lorsqu'il y a besoin de convertir le rayonnement solaire en énergie électrique. Tout en restant en configuration déployée, cette orientation est amenée à être modifiée pour conserver une orientation optimale des panneaux solaires par rapport au soleil notamment lorsque le satellite se déplace sur son orbite. La configuration déployée peut également être appelée configuration opérationnelle. Autrement dit, dans la configuration déployée les panneaux remplissent la fonction pour laquelle ils sont destinés : les capteurs solaires fournissent une énergie électrique, les panneaux d'antenne reçoivent ou émettent un rayonnement électromagnétique... Dans la configuration stockée, les panneaux sont rangés les uns contre les autres, par exemple en phase de lancement du satellite pour leur permettre de prendre place dans la coiffe d'un lanceur.

Par ailleurs, dans le cadre d'une application dans le domaine des équipements spatiaux, les panneaux peuvent être rigides ou flexibles. Dans le cas d'un panneau flexible, il est possible d'avoir un ensemble de panneaux comprenant par exemple au moins un mètre-ruban supportant une membrane souple. La membrane souple correspond à un panneau. Dans cet exemple, l'invention est à comprendre de manière analogue. La configuration stockée dans laquelle les panneaux sont repliés les uns sur les autres et empilés au niveau d'une face de la structure porteuse est à comprendre comme une configuration dans laquelle le mètre-ruban et le panneau, c'est-à-dire la membrane souple, sont enroulés autour d'un mandrin et stockés au niveau d'une face de la structure porteuse. Et de manière similaire, pour passer de la configuration stockée à la configuration déployée, le premier panneau effectue un mouvement de rotation autour de la liaison principale. Autrement dit, la membrane souple passe en configuration déployée par déploiement du mètre-ruban en effectuant un mouvement de rotation autour du mandrin.

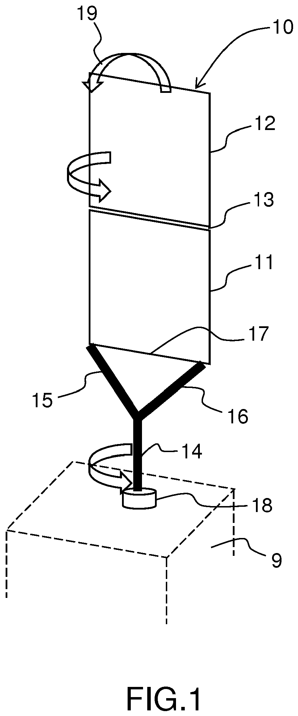

La figure 1 représente schématiquement un ensemble 10 de panneaux 11, 12 déployable et orientable selon l'art antérieur. Dans cet exemple, seuls deux panneaux 11 et 12 sont représentés. Il est bien évident que l'ensemble 10 peut aussi comprendre un ou plusieurs autres panneaux. L'ensemble 10 comprend une liaison intermédiaire définissant un axe intermédiaire de rotation 13 du panneau 12 par rapport au premier panneau 11. L'ensemble 10 de panneaux est relié à une structure porteuse 9, représentée schématiquement en pointillés sur la figure, par un bras 14 s'étendant vers l'ensemble 10 de panneaux par deux bras 15, 16. Les bras 15, 16 sont reliés à la première arête 17 du premier panneau 11. Le bras 14 est relié à un dispositif de commande 18 qui permet d'orienter l'ensemble 10 de panneaux vers le soleil. Le bras 14 associé au dispositif de commande 18 permet une rotation de 360° de l'ensemble 10 de panneaux. Ainsi, il est possible pour le satellite de s'orienter de manière à pointer complètement vers le sol et d'orienter l'ensemble 10 de panneaux 11, 12 vers le soleil pour assurer l'apport d'énergie. Selon l'art antérieur, il y a donc une articulation dédiée au déploiement des panneaux et une articulation dédiée à l'orientation de l'ensemble 10 de panneaux 11, 12. Cette configuration n'est pas optimale pour la raideur de l'ensemble 10 de panneaux. En effet, quand le satellite change d'attitude, il faut avoir une haute précision de pointage au niveau du télescope embarqué. La présence de deux articulations entre le satellite et l'ensemble 10 de panneaux génère un problème d'amortissement. En effet, pendant le changement d'attitude du satellite, l'ensemble de panneaux peut alors être soumis à un premier mode de flexion, symbolisé par la flèche 19, excité par la manœuvre du satellite mais non contrôlé par le bras 14 motorisé assurant l'orientation de l'ensemble 10 de panneaux.

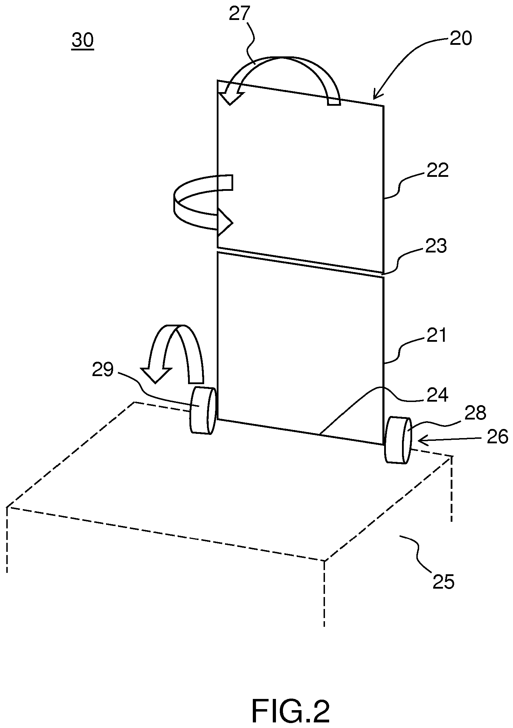

La figure 2 représente schématiquement un ensemble déployable 30 selon l'invention. L'ensemble déployable 30 comprend une structure porteuse 25, un ensemble 20 de panneaux 21, 22 déployable et orientable. Dans cet exemple, seuls deux panneaux 21 et 22 sont représentés. Il est bien évident que l'ensemble 20 peut aussi comprendre un ou plusieurs autres panneaux. L'ensemble 20 comprend une liaison intermédiaire définissant un axe intermédiaire de rotation 23 du panneau 22 par rapport au premier panneau 21. L'ensemble 20 comprend une liaison principale définissant un axe principal de rotation 24 du panneau 21 par rapport à la structure porteuse 25 représentée en pointillés sur la figure. Chacun des panneaux 21, 22 est relié au panneau adjacent par une charnière définissant l'axe de rotation intermédiaire 23. L'ensemble 20 est apte à passer d'une configuration stockée dans laquelle les panneaux 21, 22 sont repliés les uns sur les autres à une configuration déployée, par rotation des panneaux 21, 22 autour des axes de rotation intermédiaires respectifs, dans laquelle les panneaux 21, 22 sont disposés sensiblement dans un même plan. L'ensemble déployable 30 comprend un dispositif d'articulation 26 définissant l'axe principal de rotation 24 de l'ensemble 20 de panneaux 21, 22 par rapport à la structure porteuse 25. Selon l'invention, l'axe principal de rotation est sur une première arête d'un premier 21 des panneaux sur une face de la structure porteuse 25. L'ensemble 20 de panneaux 21, 22 est mobile en rotation autour des axes de rotation intermédiaires 23 et de l'axe principal de rotation 24 pour passer de la configuration stockée à la configuration déployée et l'ensemble 20 de panneaux 21, 22 est seulement mobile en rotation autour de l'axe principal de rotation 24 en configuration déployée de façon à orienter l'ensemble 20 de panneaux 21, 22 par rapport à la structure porteuse 25. C'est donc en configuration déployée, c'est-à-dire en configuration opérationnelle, que l'ensemble 20 de panneaux 21, 22 est orientable selon l'axe principal de rotation 24. Comme expliqué précédemment, pendant le changement d'attitude du satellite, l'ensemble 20 de panneaux 21, 22 peut être soumis à un premier mode de flexion, symbolisé sur cette figure par la flèche 27, excité par la manœuvre du satellite mais est, grâce à l'invention, contrôlé par le dispositif d'articulation 26 assurant l'orientation de l'ensemble 20 de panneaux 21, 22. En position déployée, la rotation de l'ensemble 20 de panneaux 21, 22 se fait autour du seul et unique axe principal de rotation 24. Il n'y a pas d'autre articulation qui intervient dans la rotation de l'ensemble 20 de panneaux 21, 22. Autrement dit, le déploiement des panneaux 21, 22 puis, une fois déployés, l'orientation de l'ensemble 20 des panneaux 21, 22 se font sur un seul axe, l'axe principal de rotation 24. Cette configuration est simple et permet d'obtenir une bonne rigidité de l'ensemble 20 sur la structure porteuse, même lorsque les panneaux sont déployés et que le satellite change d'attittude.

Comme déjà mentionné, l'invention ne se limite pas à un ensemble déployable 30 comprenant un ensemble de panneaux 20 comprenant deux panneaux 21, 22. Chacun des panneaux a des arêtes, et l'axe principal de rotation est sur une première arête d'un premier panneau et les axes de rotation intermédiaires sont avantageusement sur des arêtes non adjacentes. C'est notamment le cas avec des panneaux rectangulaires, comme représenté sur la figure 2, mais cela est vrai pour tout panneau de forme polygonale de degré supérieur ou égal à 4, c'est-à-dire à 4 arêtes ou plus.

Avantageusement, et comme représenté sur la figure 2, l'axe principal de rotation 24 et les axes de rotation intermédiaires 23 sont des axes parallèles. Cela est vrai pour des panneaux rectangulaires, mais l'axe principal de rotation 24 et les axes de rotation intermédiaires 23 peuvent aussi être parallèles pour des panneaux de forme pentagonale, hexagonale, octogonale, etc.

Comme représenté sur la figure 2, le dispositif d'articulation comprend deux paliers 28, 29 sur la première arête du premier panneau 21 de façon à rendre l'ensemble 20 de panneaux 21, 22 mobile en rotation autour de l'axe principal de rotation 24.

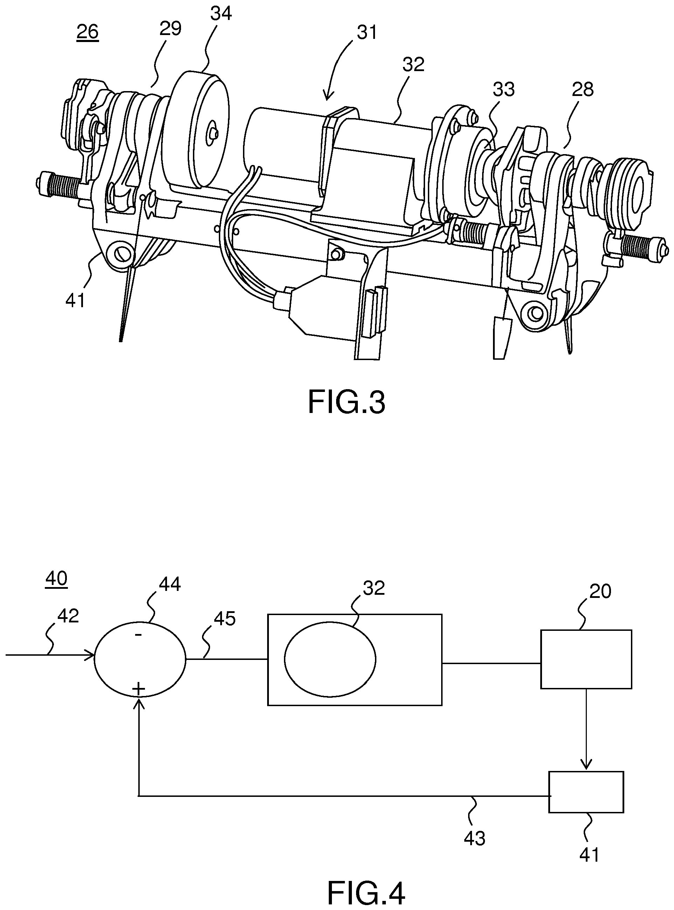

La figure 3 représente plus en détail un exemple de dispositif d'articulation 26 d'un ensemble 20 de panneaux 21, 22 par rapport à la structure porteuse 25. Le dispositif d'articulation 26 comprend le premier palier 28 sur la première arête du premier panneau 21. Le dispositif d'articulation 26 comprend un dispositif de commande 31 comprenant un motoréducteur 32 accouplé au premier palier 28 destiné à orienter l'ensemble 20 de panneaux 21, 22. Le dispositif de commande 31 comprend au moins un amortisseur 33 accouplant le motoréducteur 32 et le premier palier 28. L'amortisseur 33 a pour but d'introduire un amortissement passif dans la liaison entre le motoréducteur 32 et le premier palier 28. Autrement dit, l'amortisseur 33 sert à limiter, voire supprimer les vibrations présentes au niveau du motoréducteur quand celui-ci oriente l'ensemble 30 de panneaux par l'intermédiaire du premier palier 28. L'amortisseur 33 peut être par exemple une pièce en matériau souple tel que le caoutchouc ou le plastique pour amortir les vibrations de faibles amplitudes, un ressort ou préférentiellement un insert viscoélastique.

Selon un mode de réalisation préférentiel, le dispositif d'articulation 26 comprend moyen de précontrainte 34 associé au second palier 29 permettant d'éviter tout jeu dans le premier et le second palier 28, 29. Le moyen de précontrainte 34 constitue un système anti-jeu par mise en tension du dispositif d'articulation 26 et de l'ensemble 20 de panneaux 21, 22. Le moyen de précontrainte peut précontraindre l'amortisseur 33 et améliore ainsi le contrôle de l'ensemble 20 de panneaux 21, 22.

La figure 4 représente schématiquement une boucle d'asservissement 40 du motoréducteur 32 en fonction de la position de l'ensemble 20 de panneaux 21, 22 autour de l'axe principal de rotation, selon l'invention. L'ensemble déployable 30 comprend un capteur 41, visible sur la figure 3, apte à déterminer la position de l'ensemble 20 de panneaux 21, 22. L'ensemble déployable 30 comprend un asservissement du motoréducteur 32 en fonction de la position de l'ensemble 20 de panneaux 21, 22. Une consigne 42 est transmise au motoréducteur 32 pour orienter l'ensemble 20 de panneaux. Le capteur 42 détermine la position de l'ensemble 20 de panneaux. L'information 43 de la position de l'ensemble 20 de panneaux est transmise à un comparateur 44 qui compare l'information 43 à la consigne 42. Si l'information 43 est différente de la consigne 42, le comparateur 44 transmet une correction 45 au motoréducteur de façon à corriger l'orientation de l'ensemble 20 de panneaux. Ainsi, grâce à la boucle d'asservissement, une orientation précise de l'ensemble 20 de panneaux est assurée. Le capteur 41 peut être par exemple un capteur optique qui détermine la position de l'ensemble 20 de panneaux 21, 22. Le capteur 41 peut aussi être un capteur d'effort qui détermine, à partir de la force perçue, la position de l'ensemble 20 de panneaux 21, 22. Cette boucle de contrôle pourra aussi avantageusement recevoir une consigne élaborée par le système de contrôle d'attitude du satellite lui-même qui comprend d'autres capteurs. Autrement dit, il est possible d'envisager la boucle d'asservissement 40 comme étant une sous-boucle du système de contrôle d'attitude et d'orbite du satellite.

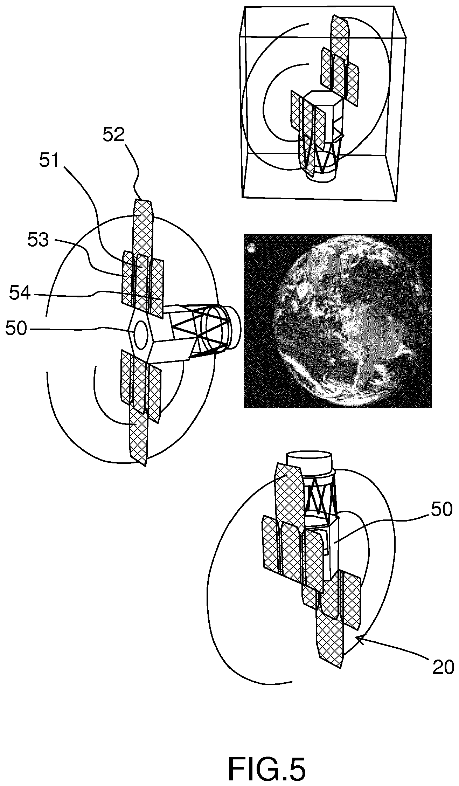

La figure 5 représente différentes positions successives autour de la Terre d'un satellite 50 selon l'invention. Autrement dit, la structure porteuse est le satellite 50. La structure déployable comprend un ensemble 20 de panneaux 51, 52, 53, 54, chacun des panneaux étant relié au panneau adjacent par une charnière définissant un axe de rotation intermédiaire, et l'ensemble de panneaux est seulement mobile en rotation autour de l'axe principal de rotation en configuration déployée de façon à orienter l'ensemble de panneaux par rapport au satellite 50. On peut noter au passage que l'invention s'applique à un ensemble de panneaux comprenant plus que deux panneaux comme représenté sur la figure 5. L'ensemble 20 de panneaux peut comprendre des panneaux dits principaux tels que les panneaux 51 et 52 et des panneaux dits secondaires 53, 54, reliés à un ou plusieurs panneaux principaux par une liaison intermédiaire. Sur le même principe, d'autres panneaux peuvent tout aussi bien être reliés aux panneaux secondaires, de façon à former toute configuration possible de l'ensemble de panneaux.

La figure 5 représente un satellite 50 en mission d'observation autour de la Terre devant à la fois effectuer un pointage vers le sol pour faire une ou plusieurs images de la Terre ou télécharger des données vers une station positionnée au sol et orienter correctement l'ensemble 20 de panneaux vers le soleil de façon à charger la batterie avec efficacité pour faire fonctionner le matériel à bord du satellite 50. Grâce à l'invention, dans une trajectoire allant du pôle Sud au pôle Nord, on voit que le satellite 50 pointe toujours vers la Terre, ce qui permet de réaliser la mission d'observation comme souhaité. Et selon la position du satellite 50 autour de la Terre et donc selon son orientation par rapport au soleil, l'ensemble de panneaux est mobile en rotation autour de l'axe principal de rotation en configuration déployée. Ainsi, l'ensemble 20 de panneaux est orientable par rapport à la structure porteuse et orienté de manière optimale pour capter le flux solaire. Comme l'orientation de l'ensemble de panneaux solaires est optimale, il n'est pas nécessaire d'en prévoir un trop grand nombre. Ainsi, le satellite 50 peut effectuer sa mission d'observation sans subir une pénalité de masse et d'encombrement due aux panneaux solaires.

Ainsi, le satellite peut toujours pointer vers la Terre et l'ensemble 20 de panneaux peut être orienté vers le soleil afin d'assurer le besoin d'énergie et faire fonctionner le matériel embarqué à bord du satellite. L'invention présente donc l'avantage de répondre à la fois aux contraintes de pointage vers le sol pour la mission d'observation et l'orientation efficace de l'ensemble de panneaux vers le soleil pour charger la batterie avec efficacité sans pénalité de masse puisqu'il n'est alors pas nécessaire de prévoir un trop grand nombre de panneaux solaires.

De manière générale, l'attitude du satellite est déterminée par un ou plusieurs suiveurs stellaires, plus connu sous la terminologie anglo-saxonne « star tracker », dispositif optique qui mesure la position des étoiles par des cellules photoélectriques ou caméras et qui permet d'en déduire l'attitude du satellite. Ces dispositifs optiques ne peuvent pas regarder à travers les panneaux, ce qui est problématique quand le satellite est équipé d'un grand nombre d'ensembles de panneaux. L'invention permet également de résoudre ce problème puisqu'elle permet, comme expliqué ci-dessus, un gain de place du fait d'un nombre d'ensembles de panneaux limité.

De plus, comme le satellite ne présente qu'une seule liaison principale pour l'orientation de l'ensemble de panneaux, le contrôle du satellite n'est pas pénalisé. En effet, chaque liaison additionnelle entre la structure porteuse et les panneaux représente un point faible supplémentaire en termes de mode de vibration. En présence de plusieurs liaisons, il faut alors amortir les modes de l'ensemble de panneaux avec des systèmes mécaniques ajoutant une contrainte de masse, un surcoût de fabrication et une complexité d'utilisation. L'invention résout ce problème grâce à son dispositif d'articulation de l'ensemble des panneaux. Le premier mode de flexion est contrôlé par le dispositif d'articulation qui permet de contrôler les vibrations par le biais du dispositif de commande. S'il y a des vibrations dans l'ensemble de panneaux, le dispositif de commande peut envoyer l'ordre au motoréducteur pour amortir les vibrations.

Par ailleurs, l'écartement entre le premier et le second palier le long de la première arête du premier panneau augmente la raideur de l'ensemble de panneaux grâce à une meilleure rigidité et permet un meilleur contrôle en fréquence.

## Revendications

1. Ensemble déployable (30) comprenant :
• une structure porteuse (25, 50),
• un ensemble (20) de panneaux (21, 22 ; 51, 52, 53, 54), chacun des panneaux (21, 22 ; 51, 52, 53, 54) étant relié au panneau adjacent par une charnière définissant un axe de rotation intermédiaire, apte à passer d'une configuration stockée dans laquelle les panneaux (21, 22; 51, 52, 53, 54) sont repliés les uns sur les autres à une configuration déployée, par rotation des panneaux (21, 22 ; 51, 52, 53, 54) autour des axes de rotation intermédiaires respectifs, dans laquelle les panneaux sont disposés sensiblement dans un même plan,
• un dispositif d'articulation (26) définissant un unique axe principal de rotation de l'ensemble (20) de panneaux (21, 22 ; 51, 52, 53, 54) par rapport à la structure porteuse (25, 50),
l'axe principal de rotation étant sur une première arête d'un premier (21, 51) des panneaux sur une face de la structure porteuse (25, 50), l'ensemble (20) de panneaux (21, 22 ; 51, 52, 53, 54) étant mobile en rotation autour des axes de rotation intermédiaires et de l'axe principal de rotation pour passer de la configuration stockée à la configuration déployée et l'ensemble (20) de panneaux (21, 22 ; 51, 52, 53, 54) étant seulement mobile en rotation autour de l'axe principal de rotation en configuration déployée de façon à orienter l'ensemble (20) de panneaux (21, 22 ; 51, 52, 53, 54) par rapport à la structure porteuse (25, 50),
**caractérisé en ce que** le dispositif d'articulation (26) comprend un premier palier (28) et un deuxième palier (29) sur la première arête du premier panneau (21, 51) de façon à rendre l'ensemble (20) de panneaux mobile en rotation autour de l'axe principal de rotation, l'axe principal de rotation étant sur une première arête d'un premier (21, 51) des panneaux, **en ce que** le dispositif d'articulation (26) comprend un dispositif de commande (31) comprenant un motoréducteur (32) accouplé au premier palier (28) destiné à orienter l'ensemble (20, 50) de panneaux, et **en ce que** le dispositif de commande (31) comprend au moins un amortisseur (33) accouplant le motoréducteur (32) et le premier palier (28).

2. Ensemble déployable (30) selon la revendication 1, chacun des panneaux (21, 22 ; 51, 52, 53, 54) ayant des arêtes, **caractérisé en ce que** les axes de rotation intermédiaires sont sur des arêtes non adjacentes.

3. Ensemble déployable (30) selon l'une quelconque des revendications précédentes, **caractérisé en ce que** l'axe principal de rotation et les axes de rotation intermédiaires sont des axes parallèles.

4. Ensemble déployable (30) selon l'une quelconque des revendications 1 à 3, **caractérisé en ce qu'**il comprend un capteur (41) apte à déterminer la position de l'ensemble (20) de panneaux, et **en ce qu'**il comprend un asservissement du motoréducteur (32) en fonction de la position de l'ensemble (20) de panneaux autour de l'axe principal de rotation.

5. Ensemble déployable (30) selon l'une quelconque des revendications 1 à 4, **caractérisé en ce que** le dispositif de commande (31) comprend un moyen de précontrainte (34) associé au second palier (29) permettant d'éviter tout jeu dans le premier et le second palier (28, 29).

6. Ensemble déployable (30) selon l'une quelconque des revendications précédentes, **caractérisé en ce que** les panneaux (21, 22 ; 51, 52, 53, 54) sont des panneaux solaires et **en ce que** la structure porteuse (25, 50) est un satellite.

## Patentansprüche

1. Entfaltbare Anordnung (30), Folgendes beinhaltend:
• eine Trägerstruktur (25, 50),
• einen Satz (20) von Platten (21, 22; 51, 52, 53, 54), wobei jede der Platten (21, 22; 51, 52, 53, 54) mit der benachbarten Platte durch ein Scharnier verbunden ist, welches eine Zwischendrehachse definiert, die in der Lage ist, von einer verstauten Konfiguration, bei welcher die Platten (21, 22; 51, 52, 53, 54) übereinander gefaltet sind, in eine entfaltete Konfiguration durch Drehung der Platten (21, 22; 51, 52, 53, 54) um die jeweiligen Zwischendrehachsen überzugehen, wobei die Platten im Wesentlichen in einer gleichen Ebene angeordnet sind,
• eine Gelenkvorrichtung (26), welche eine einzige Hauptdrehachse des Satzes (20) von Platten (21, 22; 51, 52, 53, 54) in Bezug auf die Trägerstruktur (25, 50) definiert,
wobei die Hauptdrehachse an einer ersten Kante eines ersten (21, 51) der Platten an einer Seite der Trägerstruktur (25, 50) liegt, wobei der Satz (20) von Platten (21, 22; 51, 52, 53, 54) drehbar um die Zwischendrehachsen und um die Hauptdrehachse beweglich ist, um von der verstauten Konfiguration in die entfaltete Konfiguration überzugehen, und der Satz (20) von Platten (21, 22; 51, 52, 53, 54) nur in der entfalteten Konfiguration drehbar um die Hauptachse beweglich ist, um so den Satz (20) von Platten (21, 22; 51, 52, 53, 54) in Bezug auf die Trägerstruktur (25, 50), auszurichten,
**dadurch gekennzeichnet, dass** die Gelenkvorrichtung (26) ein erstes Lager (28) und ein zweites Lager (29) an der ersten Kante der ersten Platte (21, 51) derart umfasst, dass sie den Satz (20) von Platten drehbar um die Hauptdrehachse beweglich machen, wobei sich die Hauptdrehachse an einer ersten Kante einer ersten (21, 51) der Platten befindet,
dadurch, dass die Gelenkvorrichtung (26) eine Steuervorrichtung (31) umfasst, umfassend einen Getriebemotor (32), gekoppelt mit dem ersten Lager (28), dazu bestimmt, die Gruppe (20, 50) von Platten auszurichten, und dadurch, dass die Steuervorrichtung (31) mindestens einen Dämpfer (33) beinhaltet, welcher den Getriebemotor (32) und das erste Lager (28) koppelt.

2. Entfaltbare Anordnung (30) nach Anspruch 1, wobei jede der Platten (21, 22; 51, 52, 53, 54) Kanten aufweist, **dadurch gekennzeichnet, dass** sich die Zwischendrehachsen an nicht benachbarten Kanten befinden.

3. Entfaltbare Anordnung (30) nach einem der vorhergehenden Ansprüche, **dadurch gekennzeichnet, dass** die Hauptdrehachse und die Zwischendrehachsen parallele Achsen sind.

4. Entfaltbare Anordnung (30) nach einem der Ansprüche 1 bis 3, **dadurch gekennzeichnet, dass** sie einen Sensor (41) umfasst, welcher in der Lage ist, die Position des Satzes (20) von Platten zu bestimmen, und dadurch, dass sie eine Regelung des Getriebemotors (32) angesichts der Position des Satzes (20) von Platten um die Hauptdrehachse umfasst.

5. Entfaltbare Anordnung (30) nach einem der Ansprüche 1 bis 4, **dadurch gekennzeichnet, dass** die Steuervorrichtung (31) ein Vorspannmittel (34) umfasst, welches dem zweiten Lager (29) zugeordnet ist, welches es ermöglicht, jegliches Spiel in dem ersten und dem zweiten Lager (28, 29) zu vermeiden.

6. Entfaltbare Anordnung (30) nach einem der vorhergehenden Ansprüche, **dadurch gekennzeichnet, dass** die Platten (21, 22; 51, 52, 53, 54) Solarkollektoren sind, und dadurch, dass die Trägerstruktur (25, 50) ein Satellit ist.

## Claims

1. Deployable assembly (30) comprising :
• a supporting structure (25, 50),
• a set (20) of panels (21, 22; 51, 52, 53, 54), each of the panels (21, 22; 51, 52, 53, 54) being linked to the adjacent panel by a hinge defining an intermediate axis of rotation, capable of switching from a stowed configuration, in which the panels (21, 22; 51, 52, 53, 54) are folded one on top of the other, to a deployed configuration, by rotation of the panels (21, 22; 51, 52, 53, 54) about the respective intermediate axes of rotation, in which the panels are arranged substantially in a same plane,
• an articulation device (26) defining a single main axis of rotation of the set (20) of panels (21, 22; 51, 52, 53, 54) relative to the supporting structure (25, 50),
wherein the main axis of rotation is on a first edge of a first (21, 51) of the panels on a face of the supporting structure (25, 50), the set (20) of panels (21, 22; 51, 52, 53, 54) being rotationally mobile about the intermediate axes of rotation and the main axis of rotation to switch from the stowed configuration to the deployed configuration and the set (20) of panels (21, 22; 51, 52, 53, 54) being only rotationally mobile about the main axis of rotation in deployed configuration so as to orient the set (20) of panels (21, 22; 51, 52, 53, 54) relative to the supporting structure (25, 50),
**characterized in that** the articulation device (26) comprises a first bearing (28) and a second bearing (29) on the first edge of the first panel (21, 51) so as to render the set (20) of panels rotationally mobile about the main axis of rotation, the main axis of rotation being on a first edge of a first (21, 51) of the panels,
**in that** the articulation device (26) comprises a control device (31) comprising a gear motor (32) coupled to the first bearing (28) intended to orient the set (20, 50) of panels, and **in that** the control device (31) comprises at least one damper (33) coupling the gear motor (32) and the first bearing (28).

2. Deployable assembly (30) according to claim 1, each of the panels (21, 22; 51, 52, 53, 54) having edges, **characterized in that** the intermediate axes of rotation are on non-adjacent edges.

3. Deployable assembly (30) according to any one of the preceding claims, **characterized in that** the main axis of rotation and the intermediate axes of rotation are parallel axes.

4. Deployable assembly (30) according to any one of claims 1 to 3, **characterized in that** it comprises a sensor (41) capable of determining the position of the set (20) of panels, and **in that** it comprises a servo controlling of the gear motor (32) as a function of the position of the set (20) of panels about the main axis of rotation.

5. Deployable assembly (30) according to any one of claims 1 to 4, **characterized in that** the control device (31) comprises a prestressing means (34) associated with the second bearing (29) making it possible to avoid any play in the first bearing and the second bearing (28, 29).

6. Deployable assembly (30) according to any one of the preceding claims, **characterized in that** the panels (21, 22; 51, 52, 53, 54) are solar panels and **in that** the supporting structure (25, 50) is a satellite.
